# EUROPEAN PATENT SPECIFICATION

(11) **EP 0 281 324 B1**
(45) Date of publication and mention of the grant of the patent: **19.07.2000**
(21) Application number: 88301637.0
(22) Date of filing: 25.02.1988
(51) Int. Cl.: H01L 21/318, H01L 23/48

(54) **Improved passivation for integrated circuit structures**
Passivationsschicht für integrierte Schaltungsstruktur
Structure de passivation pour structures de circuits intégrés

(30) Priority: 04.03.1987 US 21828
(43) Date of publication of application: 07.09.1988
(73) Proprietor: ADVANCED MICRO DEVICES, INC., Sunnyvale, CA 94088-3453 (US)
(72) Inventor: Allen, Bert L., Los Altos California 94022 (US); Gwozdz, Peter S., Cupertino California 95014 (US); Bowers, Thomas R., Austin Texas 78746 (US)
(74) Representative: Sanders, Peter Colin Christopher

(56) References cited:
- EP-A- 0 025 717
- EP-A- 0 186 443
- US-A- 4 587 138
- IEEE 23RD ANNUAL PROCEEDINGS OF THE INTERNATIONAL RELIABILITY PHYSICS SYMPOSIUM, 1985, pages 126-137, IEEE/IRPS; J.T. YUE et al.: "Stress induced voids in aluminum interconnects during IC processing"
- IDEM
- RCA REVIEW, vol. 40, no. 1, March 1979, pages 22-58; A. ROSEN et al.: "High-power low-loss PIN diodes for phased-array radar"
- IEEE INTERNATIONAL RELIABILITY PHYSICS SYMPOSIUM, 1986, pages 24-29, IEEE/IRPS; H. KOYAMA et al.: "Suppression of stress induced aluminum void formation"
- EXTENDED ABSTRACTS, vol. 83, no. 2, 1983, pages 510-511, abstract no. 321, Pennington, New Jersey, US; J.K. CHU et al.: "Plasma CVD oxynitride as a dielectric and passivation film"
- J Electrochem.Soc.: Solid-State Science and Technology, vol. 129, No.8, pages 1773-1778, August 1982
- Pat. Abs. Jap, vol.3, No.119, (E-142), 6.10.79 & JP-A-54 097 372
- VLSI Technology, Ed S.M.Sze, McGraw Hill Book Co,1983, pages 120-125
- IEEE Transactions on electron devices, vol. ED-25, No. 10, pages 1185-1193, 1978
- An introduction to semiconductor microtechnology, Second Edition, D.V. Morgan, K Board, pages 34-35

## Description

This invention relates to integrated circuit structures. More particularly, this invention relates to improved passivation of integrated circuit structures, including the EPROM type, to mitigate or eliminate the formation of voids in underlying metal layers.

In the construction of integrated circuit devices, a topside or "passivation" layer of a dielectric material is conventionally provided over the underlying layers comprising the integrated circuit structure. This layer, in addition to functioning as an insulation layer, acts to protect the underlying structure from moisture and ion contamination which can damage or destroy the structure by causing corrosion and electrical shorts.

The passivation material, then, should be relatively impervious to moisture and other contaminants. Silicon nitride (principally Si₃N₄) is known as a satisfactory insulation material for forming a passivation or encapsulation layer for an integrated circuit structure which provides excellent protection from moisture and ion contamination.

The use of silicon nitride as such a passivation material is discussed in various publications and patents such as M.J. Rand et al in "Optical Absorption as a Control Test for Plasma Silicon Nitride Deposition", J. Electrochemical Soc., Solid-State Science and Technology, Vol. 125, No. 1, January 1978, at pp. 99-101; A.K. Sinha et al in "Reactive Plasma Deposited SiN Films for MOS-LSI Passivation", J. Electrochemical Soc., Solid-State Science and Technology, Vol. 125, No. 4, April 1978, at pp. 601-608; G.M. Samuelson et al in "The Correlations Between Physical and Electrical Properties of PECVD SiN with Their Composition Ratios", J. Electrochemical Soc., Solid-State Science and Technology, Vol. 129, No. 8, August 1982, at pp. 1773-1778; T.E. Nagy et al in "Physical and Electrical Properties of Plasma Deposited Silicon Nitride Films", ECS Proceedings of the Symposium on Silicon Nitride Thin Insulating Films, Vol. 83-8, 1983, pp. 167-176; Engle U.S. Pat. 4,223,048; Takasaki U.S. Pat. 4,406,053; Harari U.S. Pat. 4,448,400; and Turi et al U.S. Pat. 4,516,313.

The construction of non-volatile read-only memory (ROM) integrated circuit structures in which a charge may be semi-permanently stored, yet erased when desired, known as erasable programmable read only memories (EPROMS) is described in various publications and patents including D. Frohman-Bentchkowsky in "FAMOS-A New Semiconductor Charge Storage Device", Solid-State Electronics, Vol. 17, 1974, pp. 517-529; R.D. Katznelson et al in "An Erase Model for FAMOS EPROM Devices". IEEE Transactions on Electron Devices, Vol. ED-27, no. 9, September, 1980, at pp. 1744-1752; and in Du et al U.S. Pat. 4,393,479.

Such devices store a charge on a floating gate of an MOS type device which charge may be removed (to erase the device) by exposure of the device to UV light which passes through the encapsulant or passivation layer to reach the charge on the floating gate.

Unfortunately, however, conventional silicon nitride passivation or encapsulation layers, which might otherwise be used in such structures, are relatively opaque to UV light and do not allow a sufficient amount of energy at such wavelengths to reach the charge on the floating gate.

Thus, despite the known superior properties of silicon nitride passivation layers for encapsulating an integrated circuit structure to protect it against moisture penetration and ionic contamination, it has been conventional in the prior art to employ other, less satisfactory, encapsulants such as silicon oxide (SiO₂) and silicon oxynitride materials since they will permit transmission of sufficient electromagnetic radiation of UV wavelength therethrough to permit removal of the charge on the floating gate, i.e., permit erasure of the device.

The use of such alternative passivation layers are discussed in publications and patents such as K. Alexander et al in "Moisture Resistive, U.V. Transmissive Passivation for Plastic Encapsulated EPROM Devices", IEEE 22nd Annual Proceedings of the International Reliability Physics Symposium, April 3-5, 1984, Los Vegas, at pp. 218-222; and Takasaki et al U.S. Pat. 4,532,022 which discuss the use of silicon oxynitride films for EPROMS and Frohman-Bentchkowsky U.S. Pat. 3,660,819 which describes the use of SiO₂ over the floating gate of an EPROM device.

However, it has recently been discovered that it is possible to construct an EPROM structure using a particularly formed silicon nitride passivation layer which will provide the superior encapsulation properties of silicon nitride, yet transmit sufficient UV radiation therethrough to provide the required erasure properties as well. The method for forming such a UV-transparent layer of silicon nitride is described and claimed in Forouhi et al U.S. Pat. 4,618,541, assigned to the assignee of this invention, in which one of the present inventors is a named coinventor. An erasable programmable read only memory integrated circuit device having such a UV-transparent silicon nitride passivation layer thereon is described and claimed in copending (but allowed) U.S. Patent Application Serial No. 697,364, which is also assigned to the assignee of this invention, and in which one of the present inventors also is a named coinventor.

While such UV light-transparent silicon nitride passivation layers have been found to perform satisfactorily in both encapsulating the integrated circuit device and permitting erasure with UV light, such silicon nitride passivation layers may be formed in an excessively compressive stress mode which, in turn, can result in the formation of undesirable voids in the underlying metal layer, e.g., an aluminum layer, used in the formation of the erasable gate structure beneath the silicon nitride passivation layer. Creation of such voids is believed to be the result of migration of metal atoms in the stressed metal layer.

The creation of voids in aluminum, apparently induced by an overlying silicon nitride passivation layer in conventional integrated circuit structures wherein the silicon nitride layer is not transparent to UV energy, was earlier discussed by J.T. Yue et al in "Stress Induced Voids in Aluminum Interconnects During IC Processing' IEEE 23rd Annual Proceedings of the International Reliability Physics Symposium, 1985, at pp. 126-137.

As pointed out in this article, creation of such voids in the metal wiring can result in failure of the integrated circuit structure. It is, therefore, important to be able to construct an integrated circuit structure which not only will provide the desired degree of protection against moisture and ion contamination penetration, but also inhibit the formation of voids in the underlying metal wiring of the structure as well.

An abstract in "Extended Abstracts" vol. 83 (1983) pp 510-511 considers the use of a plasma oxynitride film as a replacement for a plasma nitride film between two metal layers in an integrated circuit.

An article in "RCA Review" vol. 40 (1979) pp 28-29 and 35-36 discloses a silicone nitride passivation layer for PIN diodes capable of withstanding stringent environmental tests, including a moisture resistance test.

US Patent 4,587,138 discloses a semi-conductor device with a conductive layer underlying an oxynitride passivation layer, the lower portion of the oxynitride layer being provided with tensile characteristics while the upper portion of the layer has compressive characteristics.

The Journal of the Electrochemical Society "Solid-State Science and Technology" vol. 129 (1982) pp 1773-1778 discusses how properties such as mechanical stress, refractive index, and density can be controlled in a silicon nitride layer deposited by chemical vapour deposition.

JP-A-54097372 discloses a method of etching a metal layer on a substrate in which the metal is first implanted with argon ions so that, after etching, the physical dimensions of the etched metal are less likely to cause cracking of a subsequently applied insulating layer.

According to the present invention there is provided a process for producing an integrated circuit structure wherein a silicon nitride passivation layer resistant to penetration by moisture and ion contaminants is provided over an underlying metal layer, and wherein either (a) the level of compressive stress in the passivation layer is controlled and/or (b) an intermediate layer is formed between the metal layer and the passivation layer to relieve the underlying metal layer from stresses induced by the compressive stress in the passivation layer, characterised in that the surface of the metal layer is implanted with ions of a non-reactive element to change the grain structure of the surface, whereby the formation of voids in the metal layer, induced by said compressive stress in said passivation layer, is inhibited.

The invention is particularly applicable to a process in which the silicon nitride passivation layer is transparent to ultra-violet light since such layers are more likely to induce excessive compressive stress in the metal layer.

The ions are preferably implanted to a depth of between 150 and 2500 A, the density of the ions being in the region of 10¹⁵ to 10¹⁶ ions/cm² and the ions being implanted at an energy level in the range of 40kEV to 200kEV.

The intermediate layer is preferably an insulating layer formed with a tensile/compressive stress to compensate for the compressive stress in the silicon nitride layer.

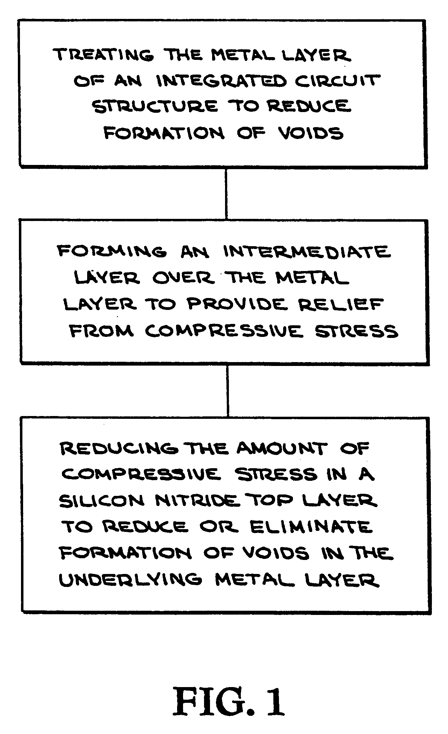

In the accompanying drawings, by way of example only:-
Figure 1 is a flowsheet illustrating a process embodying the invention, and
Figure 2 is a graph showing the effects of pressure in the reactor on the compressive/tensile stress in the formation of a silicon oxynitride layer.

Referring to the drawings an improved system for encapsulating an integrated circuit structure is provided wherein the deleterious effects of void formation in the underlying metal layer, apparently caused by metal atom migration induced by compressive stresses transmitted to the metal layer from a silicon nitride encapsulation layer, are mitigated or substantially eliminated.

In a preferred embodiment, particularly directed to the formation of an erasable programmable read only memory integrated circuit device with a passivation layer of a substantially UV transparent silicon nitride material, the deleterious formation of voids in the underlying metal layer induced by compressive stresses transmitted to the metal layer from the silicon nitride layer are mitigated or substantially eliminated.

The system in this example of the invention actually comprises three aspects: 1) treatment of the metal layer to reduce the effects of the transmission of the compressive stress from the silicon nitride layer to the metal layer by ion implantation of the metal layer to alter the grain size; 2) provision of an intermediate layer of a material, preferably a UV light transparent material, wherein the compressive/tensile stress of the intermediate layer may be adjusted to compensate for the compressive stress in the silicon nitride layer; and 3) control of the amount of compressive stress formed in the silicon nitride passivation layer, which also is preferably UV transparent.

While it is preferable to include all three steps, it is possible to omit one of the steps if all three steps are not needed to achieve sufficient stress relief to eliminate the formation of voids in the metal layer. Thus steps 1 and 2, or steps 1 and 3, may be practised in some instances without the remaining step to eliminate the formation of voids in the metal layer.

It should be noted, however, that there is a preferred hierarchy of treatment steps whether all three treatment steps are used or only two steps are used. As will be discussed in more detail below, this is because it is essential that the resistance to moisture and ion contamination penetration of the silicon nitride layer be preserved since this is one of the principal characteristics of the silicon nitride layer which makes it superior to other insulation layers.

Therefore, treatment of the metal layer and formation of the intermediate layer to eliminate the creation of voids in the metal layer will be preferred steps to take from a hierarchy standpoint before lowering the compressive stress on the silicon nitride layer since the high compressive stress on the silicon nitride layer contributes to the moisture and ion penetration resistance of that layer. Furthermore, when the silicon nitride layer is used as an encapsulant for an EPROM device wherein UV light transparency of the silicon nitride layer is required, decreasing compressive stress in the silicon nitride layer can result in an excess of silicon resulting in loss of UV light transparency.

The metal layer beneath the silicon nitride passivation layer may be treated by ion implantation to alter the grain structure in a manner which results in a reduction in the formation of large voids therein. While the exact effect of the ion implantation on the metal structure is open to more than one explanation, it is thought that the ion implantation may act to provide a graduated prestressing of the surface compressively or it may alter the crystallinity of the metal surface by, in effect, jumbling the crystals on the metal surface to provide smaller grains which, in turn, reduce the extent of metal atom migration within the metal layer which is thought to be at least one cause of void formation.

Compressive stresses transmitted to a metal surface so treated would then either not result in the creation of void or would result in the formation of smaller voids due to the smaller grain size of the metal at or adjacent to the surface of the treated metal.

The metal layer may be ion implanted with ions of a nonreactive element, such as argon, which will not have any deleterious effects on the metal layer. Other elements which may be ion implanted into the metal surface might, for example, include arsenic, boron, krypton, neon, or silicon. In at least some instances, ions of the same metal as the metal being treated could be used; e.g., implantation of an aluminum surface with aluminum ions.

The ions are implanted in the metal layer at an energy level of from about 40-200 kEV, preferably about 70-150 kEV when argon ions are being implanted, to provide a depth of about 150-2500 Å, preferably about 300-1200 Å, which may be attained at the 70-150 kEV energy level range. The dosage ranges from about 10¹⁵ to 10¹⁶ atoms per cm², preferably about 5 x 10¹⁵ when argon is being implanted. The temperature during the implantation may vary in accordance with the desired time of the dosage, ranging from as low as, for example, -10°C up to as high as 300°C, typically about 100°C.

While the metal layer being ion implanted will, in most instances, comprise an aluminum metal, it will be appreciated that the term "metal layer" is intended to embrace not only pure aluminum, but aluminum base alloys as well wherein up to 20 wt.% of the aluminum base alloy may comprise one or more other alloying metals. The metal layer may also comprise other metals as well such as, for example, tantalum and/or tungsten.

In accordance with another aspect of the system, the metal layer may be stress-relieved from compressive stress transmitted to it by the silicon nitride layer by the interposition of an intermediate layer of another material, which, in a preferred embodiment, has a controlled compressive/tensile stress therein adjusted during formation of the layer to sufficiently compensate for the compressive stress of the silicon nitride layer thereon to suppress the formation of voids in the underlying metal layer.

This intermediate layer, when used in the construction of an EPROM device, will comprise a material which is also transparent to radiation of UV wavelength so as to not interfere with the erasability of the EPROM device. However, it should be noted that the system is not limited in application to only the construction of EPROM devices, but rather may be utilized wherever deleterious compressive stresses are transmitted from a silicon nitride layer, including conventional UV-opaque passivation layers, to an underlying metal layer resulting in the formation of voids in the metal layer.

The intermediate layer should also function as an insulation layer although it need not be completely impervious to moisture and ion contaminants since the silicon nitride, not the intermediate layer, will act as the encapsulating layer. Materials which may be utilized in the formation of this intermediate layer include silicon oxynitride and silicon oxide. Silicon oxynitride is the preferred material for use in forming the intermediate layer both from ease of formation, since the integrated circuit structure may have both the silicon oxynitride and the silicon nitride layers applied using the same apparatus, and from the known ability to control the amount of compressive/tensile stress formed in a silicon oxynitride layer.

The thickness of the intermediate layer should be sufficient to provide the desired gradient or stress compensation for the compressive stress in the overlying silicon nitride layer. Thicknesses of from about 0.2 to 3 microns, preferably about 0.5 to 1.5 microns, are satisfactory.

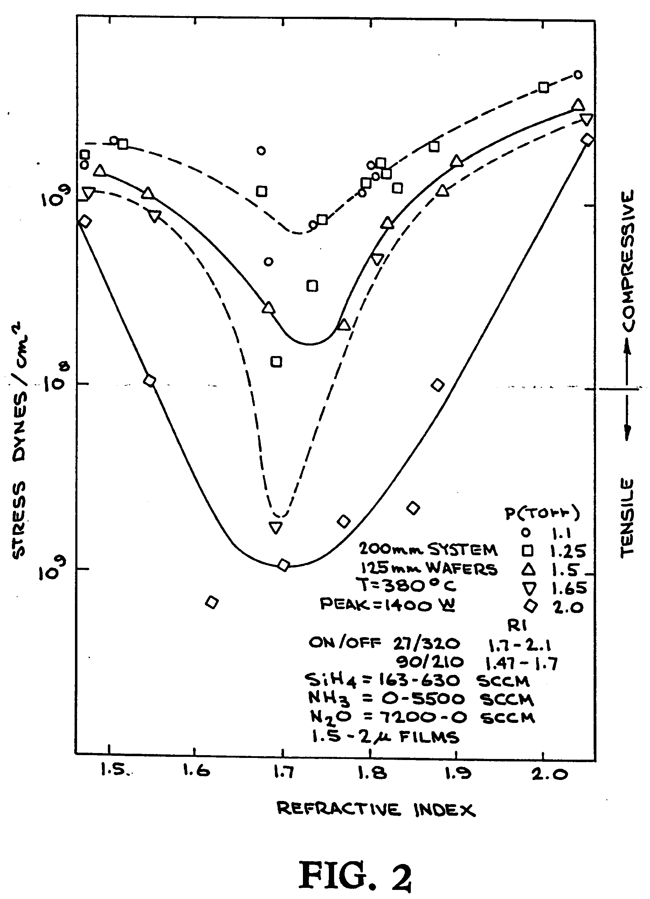

When silicon oxynitride comprises the intermediate layer, the amount of compressive/tensile stress contained in the layer may be adjusted during the formation of the layer by adjustment of the pressure in accordance with the parameters shown in ASM America Newsletter, Volume 1, No 1 of December, 1985, cross-reference to which is hereby made, and the graph shown in Figure 2. It will be seen in that graph that the use of higher pressure, i.e., greater than about 1.5 Torr, will result in a shift in the stress into a tensile stress mode.

The amount of pressure used, and the resulting amount of either compressive or tensile stress formed in the intermediate layer, will be empirically determined, in part, by the amount of compressive stress formed in the subsequently formed silicon nitride layer to result in a composite layer having a compressive/tensile stress which will usually still be on the compressive side but will be insufficient to result in the formation of voids in the underlying metal layer.

The amount of compressive stress developed in the silicon oxynitride layer may also be lowered by adjusting other parameters in the reaction process such as by lowering the RF power in the plasma deposition reactor, e.g., from a normal 1500 watts, or lowering the duty cycle of the RF power which results in the appearance of operating at a lower power. The amount of NO₂ gas used may also be increased to lower the compressive stress of the silicon oxynitride layer. Other known reaction parameters which may also have an effect on the resulting compressive stress and which are interrelated to those just mentioned such as reaction time and flow rates may also be modified as well to achieve the desired compressive/tensile stress in the silicon oxynitride layer.

With respect to the extent to which the compressive stress of the intermediate layer may be lowered, the compressive/tensile stress on the intermediate layer should be adjusted as much as possible without increasing tensile stress sufficiently to result in die cracking. This, again will be an empirical determination since the amount of tensile stress which may be applied to the intermediate layer without resulting in cracking of the die will depend upon other processing steps as well as the geometry of the particular die. However, one skilled in the art will be able to readily determine, in the finished product, whether too much tensile stress has been applied to the intermediate layer resulting in cracking of the die. It should be further noted in this regard, that when the compressive stress on the subsequently formed silicon nitride layer is decreased, adjustment in the amount of tensile stress of the silicon oxynitride layer may have to be further adjusted to prevent cracking of the die.

In yet another aspect of the invention, the amount of compressive stress formed in the silicon nitride layer may also be controlled to some extent by adjustment of the pressure, i.e., by raising the pressure, during formation of the silicon nitride layer. However, while such adjustment might, on its face, appear to be the most likely way to solve the problems resulting from the compressively stressed silicon nitride layer, it must be pointed out that the ultimate reason for using a silicon nitride encapsulation or passivation layer (and for enduring the problems created thereby) is the superior moisture and ion penetration resistance of the silicon nitride layer over layers of other material such as silicon oxide and silicon oxynitride.

Modification of the silicon nitride layer to relieve stress in the metal layer is, furthermore, a particular problem in application of the silicon nitride layer as an encapsulant for EPROMS, both due to the need for preserving UV transparency (which is related to the amount of compressive stress and which, prior to the aforesaid Forouhi et al '541 patent, was a problem in itself to achieve) and preserving the resistance to moisture penetration since an EPROM structure is particularly sensitive to moisture.

This resistance to moisture and ion penetration is achieved by forming the silicon nitride layer in a compressive stress mode. While all compressive stress, therefore, could probably be alleviated or removed by adjustment of the reaction parameters, such as by providing higher pressure or lower RF power during formation of the silicon nitride film, such would be at the expense of the excellent moisture and ion penetration resistance of the silicon nitride layer which would be counter productive. Thus the amount of pressure increase during the formation of the silicon nitride layer will be insufficient to remove the resulting silicon nitride layer from a compressive stress mode. More particularly, the compressive stress remaining on the silicon nitride layer should not be less than about 2.5 x 10⁹ dynes/cm², preferably 5 x 10⁹ dynes/cm².

When a silicon nitride layer is being used as an encapsulant for an EPROM device the amount of compressive stress remaining may be further characterized as providing the UV light transparency at 2537 Å wavelength indicated by at least a 3% reflectance value as measured, for example, by a Hewlett-Packard Diode Array Spectrophotometer Model No. 8450A and preferably sufficient UV light transparency to permit erasure of the EPROM with a dual layer film (silicon oxynitride-silicon nitride) in less than one hour at 0.02-0.03 watts/cm² using, for example, a Spectronic UV light eraser.

Furthermore, control and adjustment of the reaction parameters during formation of the silicon nitride layer which affect the compressive stress developed by the layer will always be done in combination with the treatment of the metal surface or the formation of the intermediate layer or both so as to not lose the excellent moisture and ion penetration resistance properties of the silicon nitride layer.

Furthermore, as previously discussed, the hierarchy of treatments steps will favor utilizing one or both of the first two treatments prior to lowering the compressive stress on the silicon nitride layer to lower the risk of loss of some of the excellent moisture and ion penetration resistance which characterizes a silicon nitride layer under compressive stress. Therefore, before lowering the compressive stress of the silicon nitride layer, at least one or the other of the first two steps should be performed. Furthermore, with respect to the lowering of the compressive stress of the intermediate layer, the compressive/tensile stress on the intermediate layer should be adjusted, as discussed above, as much as possible without increasing tensile stress sufficiently to result in die cracking.

The amount of adjustment of the compressive stress of the silicon nitride layer should, therefore, be insufficient to measurably increase the penetration of moisture or ion contaminates through the layer. Thus, the change in reaction conditions resulting in lowering of the compressive stress of the silicon nitride layer, e.g., raising the pressure in the PECVD system used to form the silicon nitride layer, should only be made sufficiently to result in the elimination of voids in the metal layer, and such process adjustments should only be done after at least one of the other steps has been carried out to avoid an excessive loss of compressive stress in the silicon nitride layer and resultant loss of moisture and ion penetration resistance. When the invention is practiced in connection with the encapsulation of EPROM devices, the amount of decrease in the compressive stress of the silicon nitride layer should also be insufficient to interfere with the transparency of the silicon nitride layer.

It is recognized that the practice of this system may, therefore, require the use of some empirical determinations since there will be an interrelationship between the steps. However, the desired end result, namely the elimination of voids in the metal layer induced by transmission of the compressive stress of the silicon nitride layer to the metal layer, is easily determined in the final product by microscopic techniques. Thus one skilled in the art, given the foregoing discussing of parameters, as well as the hierarchical order of treatments, will be able to practice this system and achieve the desired elimination of voids in the metal layer.

It should be noted, in this regard, that when the system is practiced in connection with the formation of an EPROM type integrated circuit structure, it is the intent that this system be practiced in combination with the process described and claimed in the aforementioned Forouhi et al '541 patent, particularly with regard to the use of amounts of silicon insufficient to result in the formation of silicon-silicon bonds. While the change in reaction parameters to lower the compressive stress of the silicon nitride layer, such as the use of higher pressures, can have deleterious effects on the moisture and ion penetration resistance of the silicon nitride layer; high pressure may result in excess silicon which can also have a deleterious effect on the UV transparency of the resulting silicon nitride layer.

While we do not intend to be bound by any theories of the mechanisms involved in the formation of transparent layers of silicon nitride, the effects of both high pressure and excess silicon atoms are thought to promote the formation of silicon-silicon bonds, rather than silicon-nitrogen bonds, which silicon-silicon bonds are thought to contribute to the opacity of conventional silicon nitride layers. In fact, it is further postulated that the reason for the increased transparency of silicon oxynitride layers may be due to the added retardation of silicon-silicon bond formation by the presence of oxygen with which the silicon atoms will bond in preference to other silicon atoms.

To further illustrate the invention, an integrated circuit structure having a patterned aluminum layer thereon was subject to an argon implantation at an energy level of 70 kEV at ambient temperature to provide an implantation of about 5 x 10¹⁵ ions/cm² to a depth of about 750Å in the aluminum surface.

A silicon oxynitride layer of about 1.35 micron thickness was then formed over the implanted aluminum layer in a plasma enhanced chemical vacuum deposition (PECVD) apparatus comprising a 1500 watt ASM Micon V plasma deposition reactor and using a duty cycle of 30 milliseconds on and 300 milliseconds off. The reactants comprised a mixture of 400 SCCM silane (SiH₄), 3000 SCCM NH₃, and 2000 SCCM N₂O and were flowed over the structure in a vacuum chamber maintained at 380°C and a pressure of 1.6 Torr to provide a deposition rate of about 200Å/minute. The deposition was carried out for 68 minutes to yield a silicon oxynitride layer having a tensile stress of 5 x 10⁸ dynes/cm² as measured with an IONIC stress gauge.

A silicon nitride layer transparent to UV radiation at 2537Å was then formed over the silicon oxynitride layer using the process of the Forouhi et al '541 patent modified somewhat to reduce the compressive stress in the silicon nitride layer using the same type of plasma enhanced chemical vacuum deposition (PECVD) apparatus as used to form the silicon oxynitride layer, i.e., a 1500 watt ASM Micon V plasma deposition reactor using a duty cycle of 30 milliseconds on and 300 milliseconds off. A gas flow of 300 SCCM silane to 5300 SCCM ammonia was used at a temperature of about 380°C and a pressure of about 2.0 Torr. The PECVD deposition was carried out for about 105 minutes to form a silicon nitride layer of about 1.35 micron thickness having a compressive stress of 5 x 10⁹ dynes/cm² as measured with an IONIC stress gauge.

After applying the silicon oxynitride and silicon nitride layers, the integrated circuit structure was visually examined under a microscope for voids. None were seen. The structure was then placed in a furnace and heated to 400°C and maintained at this temperature for 20 minutes in a nitrogen atmosphere. The structure was removed from the furnace and again examined under a microscope. Again no voids were noted. The structure was then completed and placed in an oven and heated to 200°C and held at this temperature for 20 hours in a nitrogen atmosphere. The structure was removed from the oven and again examined for voids under a microscope. No voids were found in the aluminium portion examined.

Thus, there is provided a system for the production of an integrated circuit structure encapsulated by a silicon nitride layer which provides excellent resistance to moisture and ion penetration while providing sufficient stress relief in and adjacent the underlying metal layer to prevent the formation of undesirable voids in the underlying metal layer.

## Claims

1. A process for producing an integrated circuit structure wherein a silicon nitride passivation layer resistant to penetration by moisture and ion contaminants is provided over an underlying metal layer, and wherein either (a) the level of compressive stress in the passivation layer is controlled and/or (b) an intermediate layer is formed between the metal layer and the passivation layer to relieve the underlying metal layer from stresses induced by the compressive stress in the passivation layer, characterised in that the surface of the metal layer is implanted with ions of a non-reactive element to change the grain structure of the surface, whereby the formation of voids in the metal layer, induced by said compressive stress in said passivation layer, is inhibited.

2. A process according to claim 1 in which the silicon nitride passivation layer is transparent to ultra-violet light.

3. A process according to claim 2 in which the integrated circuit structure is an EPROM and the UV transparency is sufficient to permit erasure of the EPROM in less than one hour at 0.02 to 0.03 watts/cm².

4. A process according to any one of the claims 1-3 in which the ions are implanted in a dosage of about 10¹⁵ to 10¹⁶ ions/cm² at an energy level in the range of 40 KEV to 200 KEV and to a depth of between 150 and 2500Å.

5. A process according to any one of the claims 1-4 wherein the ions are of argon, arsenic, boron, neon, krypton, or silicon.

6. A process according to any one of the claims 1-5 wherein the passivation layer is formed by plasma deposition in a reactor and wherein the reaction parameters are controlled such that the compressive stress in the passivation layer is not less than 2.5 x 10⁹ dynes/cm².

7. A process according to any one of the preceding claims in which the intermediate layer comprises an insulating layer formed with a tensile/compressive stress to compensate for the compressive stress in the passivation layer.

8. A process according to claim 7 in which the intermediate layer comprises silicon oxide or silicon oxynitride.

9. A process according to claim 8 wherein the intermediate insulating layer consists essentially of silicon oxynitride and is formed by chemical vapor deposition of a mixture of silane and an oxide of nitrogen on the metal layer while maintaining a pressure sufficiently high to compensate for the compressive stress in the passivation layer subsequently formed thereover.

10. A process according to claim 8 wherein the intermediate insulating layer consists essentially of silicon oxynitride and is formed by chemical vapor deposition of a mixture of silane and an oxide of nitrogen on the metal layer the concentration of said oxide being maintained sufficiently high to compensate for the compressive stress in the passivation layer subsequently formed thereover.

## Patentansprüche

1. Verfahren zur Herstellung einer integrierten Schaltungsstruktur, bei dem eine gegen das Eindringen von Feuchtigkeit und Ionenkontamination resistente Siliziumnitrid-Passivierungsschicht auf einer darunterliegenden Metallschicht vorgesehen ist und bei der entweder (a) die Höhe der Druckbeanspruchung in der Passivierungsschicht kontrolliert wird und/oder (b) eine Zwischenschicht zwischen der Metallschicht und der Passivierungsschicht gebildet ist, die die darunterliegende Metallschicht von durch die Druckbeanspruchung in der Passivierungsschicht hervorgerufenen Belastungen entlastet,
dadurch gekennzeichnet, daß zur Veränderung der Kornstruktur der Oberfläche Ionen eines nicht reaktiven Elementes in die Oberfläche der Metallschicht implantiert sind, wodurch die Bildung von Lücken in der Metallschicht, die durch die Druckbeanspruchung in der Passivierungsschicht verursacht werden, vermieden wird.

2. Verfahren nach Anspruch 1, bei dem die Siliziumnitrid-Passivierungsschicht für ultraviolettes Licht transparent ist.

3. Verfahren nach Anspruch 2, bei dem die integrierte Schaltungsstruktur ein EPROM ist und die UV-Transparenz zum Löschen des EPROMs in weniger als einer Stunde bei 0,02 bis 0,03 Watt/cm² ausreicht.

4. Verfahren nach einem der Ansprüche 1-3, bei dem die Ionen in einer Dosierung von ungefähr 10¹⁵ bis 10¹⁶ Ionen/cm² bei einem Energiepegel im Bereich von 40 KeV bis 200 KeV und bis zu einer Tiefe von 150 bis 2500 Å implantiert werden.

5. Verfahren nach einem der Ansprüche 1-4, bei dem die Ionen Argon-, Arsen-, Bor-, Neon-, Krypton- oder Siliziumionen sind.

6. Verfahren nach einem der Ansprüche 1-5, bei dem die Passivierungsschicht durch Plasmaauftrag in einem Reaktor gebildet ist und bei dem die Reaktionsparameter derart kontrolliert werden, daß die Druckbeanspruchung in der Passivierungsschicht 2,5 x 10⁹ Dyn/cm² nicht unterschreitet.

7. Verfahren nach einem der vorhergehenden Ansprüche, bei dem die Zwischenschicht eine der Kompensierung der Druckbeanspruchung in der Passivierungsschicht dienende Isolierschicht mit einer Zug-/ Druckbeanspruchung aufweist.

8. Verfahren nach Anspruch 7, bei dem die Zwischenschicht Siliziumoxid oder Siliziumoxynitrid enthält.

9. Verfahren nach Anspruch 8, bei dem die isolierende Zwischenschicht im wesentlichen aus Siliziumoxynitrid besteht und mittels CVD-Auftrag einer Mischung aus Silan und einem Stickstoffoxid auf die Metallschicht gebildet ist, wobei ein Druck ausreichend hoch gehalten wird, damit die Druckbeanspruchung in der später über der Metallschicht gebildeten Passivierungsschicht kompensiert wird.

10. Verfahren nach Anspruch 8, bei dem die isolierende Zwischenschicht im wesentlichen aus Siliziumoxynitrid besteht und mittels CVD-Auftrag einer Mischung aus Silan und einem Stickstoffoxid auf die Metallschicht gebildet ist, wobei die Oxidkonzentration ausreichend hoch gehalten wird, damit die Druckbeanspruchung in der später über der Metallschicht gebildeten Passivierungsschicht kompensiert wird.

## Revendications

1. Procédé de fabrication d'une structure de circuits intégrés dans lequel une couche de passivation de nitrure de silicium résistante à la pénétration de l'humidité et des contaminants ioniques est fournie sur une couche métallique sous-jacente, et dans lequel, soit (a) le degré de résistance à la compression de la couche de passivation est commandé et/ou (b) une couche intermédiaire est formée entre la couche métallique et la couche de passivation pour libérer la couche métallique sous-jacente des contraintes induites par la force de compression dans la couche de passivation, caractérisé en ce que la surface de la couche métallique est implantée avec des ions d'un élément non réactif afin de modifier la structure à grains de la surface, de façon à ce que la formation de vides dans la couche métallique, induite par ladite force de compression dans ladite couche de passivation, soit inhibée.

2. Procédé selon la revendication 1, dans lequel la couche de passivation de nitrure de silicium est transparente aux rayons ultra-violets.

3. Procédé selon la revendication 2 dans lequel la structure de circuits intégrés est une EPROM et la transparence aux UV est suffisante pour permettre un effacement de l'EPROM en moins d'une heure à une puissance de 0,02 à 0,03 watts/cm².

4. Procédé selon l'une quelconque des revendications 1 à 3 dans lequel les ions sont implantés selon une dosage d'environ 10¹⁵ à 10¹⁶ ions/cm² à un niveau d'énergie se situant dans la plage de 40 KEV à 200 KEV et à une profondeur comprise entre 150 et 2500 Å.

5. Procédé selon l'une quelconque des revendications 1 à 4, dans lequel les ions sont des ions d'argon, d'arsenic, de bore, de néon, de krypton ou de silicium.

6. Procédé selon l'une quelconque des revendications 1 à 5, dans lequel la couche de passivation est formée par dépôt sous plasma dans un réacteur et dans lequel les paramètres de réaction sont commandés de telle sorte que la force de compression dans la couche de passivation ne soit pas inférieure à 2,5 x 10⁹ dynes/cm².

7. Procédé selon l'une quelconque des revendications précédentes dans lequel la couche intermédiaire comprend une couche isolante formée avec une contrainte de compression/traction pour compenser la contrainte due à la compression dans la couche de passivation.

8. Procédé selon la revendication 7 dans lequel la couche intermédiaire comprend de l'oxyde de silicium ou de l'oxynitrure de silicium.

9. Procédé selon la revendication 8 dans lequel la couche isolante intermédiaire est constituée essentiellement d'oxynitrure de silicium et est formée par le dépôt chimique en phase vapeur d'un mélange de silane et d'un oxyde d'azote sur la couche métallique tout en maintenant une pression suffisamment élevée pour compenser la contrainte en compression exercée dans la couche de passivation formée ultérieurement sur elle.

10. Procédé selon la revendication 8 dans lequel la couche isolante intermédiaire est constituée essentiellement d'oxynitrure de silicium et est formée par un dépôt chimique en phase vapeur d'un mélange de silane et d'un oxyde d'azote sur la couche métallique, la concentration dudit oxyde étant maintenue suffisamment élevée pour compenser la contrainte de compression exercée dans la couche de passivation formée ultérieurement sur elle.
